# EUROPEAN PATENT SPECIFICATION

(11) **EP 2 949 623 B1**
(45) Date of publication and mention of the grant of the patent: **26.11.2025**
(21) Application number: 12891335.7
(22) Date of filing: 22.01.2013
(51) Int. Cl.: B82B 3/00, B82Y 40/00, C01B 32/15

(54) **METHOD FOR PRODUCING CARBON NANOSTRUCTURES, AND DEVICE**
VERFAHREN ZUR HERSTELLUNG VON NANOSTRUKTUREN UND VORRICHTUNG
PROCEDE DE FABRICATION DE NANOSTRUCTURES D'HYDROCARBURES ET APPAREIL CORRESPONDANT

(43) Date of publication of application: 02.12.2015
(73) Proprietor: MCD Technologies S.a.r.l, 3364 Leudelange (LU)
(72) Inventor: PREDTECHENSKIY, Mikhail Rudolfovich, Leudelange (LU)
(74) Representative: Hoffmann Eitle
(86) International application number: PCT/RU2012/001053
(87) International publication number: WO 2014/116134

(56) References cited:
- WO-A1-03/072859
- RU-A- 2011 115 430
- RU-C2- 2 419 585
- RU-C2- 2 465 198
- US-A1- 2007 266 825
- US-A1- 2008 216 604
- US-A1- 2012 195 820
- US-B1- 8 137 653
- ANNA MOISALA ET AL: "Single-walled carbon nanotube synthesis using ferrocene and iron pentacarbonyl in a laminar flow reactor", CHEMICAL ENGINEERING SCIENCE, vol. 61, no. 13, 1 July 2006 (2006-07-01), GB, pages 4393 - 4402, XP055291133, ISSN: 0009-2509, DOI: 10.1016/j.ces.2006.02.020
- VIVEKCHAND S R C ET AL: "Carbon nanotubes by nebulized spray pyrolysis", 20040311, vol. 386, no. 4-6, 11 March 2004 (2004-03-11), pages 313 - 318, XP002408269

## Description

### FIELD OF THE INVENTION

The present invention relates to the process for producing carbon nanostructure by the catalytic decomposition of hydrocarbons and to an apparatus for their production.

### BACKGROUND ART

In recent years, carbon nanostructures attract more and more attention due to the possibility of obtaining new materials with unique properties. The nanostructures include fullerenes, carbon nanotubes (CNT) and nanowires, nanodiamonds, and carbon bulbous structures, graphene and others. Of these articles, nanotubes are of plurality of types that vary in structure, diameter, chirality, and a number of layers.

Various methods for producing carbon nanostructures disclosed in the art includes in partucular a method of thermal decomposition of hydrocarbons on the catalyst surface.

For example, there is well-known Bayer method for producing carbon nanotubes [http://www.baytubes.com/]. This method comprises decomposition of hydrocarbon gases in a reaction chamber with fluidized catalyst. This catalyst is prepared in advance and is in the form of particles consisting of a substrate and deposited on its surface active catalytic substance. In the reaction chamber, the catalyst particles come down from above, and the gaseous substances (carbon sources) come from the bottom upwards, towards the catalyst nanoparticles. Multiwall carbon nanotubes grow on the substrate with the catalyst in the form of agglomerates. The agglomerates are removed from the reaction chamber during filtration separating them from the gas phase.

The method described above provides production of nanotubes in largescale in the continuous process. However, production of multiwall nanotubes in the form of agglomerates is one of the shortcomings of the process. Such tubes have low quality, and further complicated dispersion of the agglomerates is required for obtaining a product suitable for applications.

A continuous process for the production of carbon nanotubes is disclosed in prior art. It is proposed by Cambridge University Technical Services [UK application number 2485339, IPC C01B31/02]. In accordance with this method, the reaction chamber is filled with a gas mixture consisting of: a carbon source (e.g., methane CH₄), vapor of the catalyst substance (e.g., ferrocene Fe(C₅H₃)₂), and a retarding agent (e.g., carbon disulfide CS₂). The reaction chamber of the tubular shape, for example having a length of 2 m and the diameter of 0.08 m is heated by electrical heaters. The temperature in the reaction chamber is sufficient to decompose the catalyst substance. At this temperature atoms of a transition metal are released (e.g., iron Fe), which leads to the growth of the catalyst nanoparticles. At the same time, the retarding agent is decomposed releasing sulfur S atoms, resulting in stunted growth of the catalyst particles. Preparation of the catalyst nanoparticles of desired size is achieved by varying the ratio of the catalyst substance and the retarding agent, and by the selected temperature. Single-walled carbon nanotubes are formed when the transition metal contacts the carbon source.

In this method, as described above, the catalyst nanoparticles are formed directly in the volume of the reaction chamber. In the same volume, nanotubes grow on the surface of nanoparticles of the catalyst. It is obvious that such different in nature processes make their control and optimization difficult. Accordingly, there is the problem of controlling the properties of obtained carbon nanostructures.

For solving this problem, it is advisable to separate the process of producing the catalyst nanoparticles, preparation of the nanoparticle mixture, the carrier gas, and hydrocarbons, heating of the reaction mixture and the final reaction of formation of carbon nanostructures. In this division at the step of formation of catalyst nanoparticles, there is an opportunity to control and optimize the growth of carbon nanostructures. Preparing a predetermined gas mixture at the required temperature allows controlling the speed of stirring various gas components and facilitating the control of the entire process of producing carbon nanostructures.

It should be noted also that in the apparatus, where the carbon nanostructures grow on free catalyst nanoparticles, only a relatively small volume of the reaction chamber is used. Firstly, it affects productivity. Secondly, because of the small volume of the reaction chamber there is a great influence of its walls on the process therein. The carbon nanotubes are deposited and grown on the walls filling the volume of the chamber, and changing the conditions of their formation. Deposition and growth of the tubes on the walls are due to the fact that during the typical residence times of the gaseous mixture in the reaction chamber (from a few to tens of seconds), the atoms and molecules of the mixture repeatedly collide with the wall of the chamber, whereby there are two different processes of formation of the nanoparticles: one process is the formation of free carbon nanoparticles in the gas phase on the surface of the catalyst nanoparticle, and the other is the formation of nanoparticles on the surface of the walls of the reaction chamber. Obviously, the optimum conditions for the formation of nanoparticles in the gas phase and on the wall surface is different, so the control of the process is complicated. On the other hand, the formation of nanoparticles on the walls of the reaction chamber complicate withdrawal of the carbon nanoparticles from it resulting in lower reactor productivity and increase in the cost of the final product.

A method of producing single-walled and multi-walled carbon nanotubes based on the use of a hot filament as a source of catalyst nanoparticles in the reaction chamber is disclosed in prior art [A. G. Nasibulin, Development of technologies for the production of nanoscale powders and carbon nanotubes by chemical vapor deposition. Doctoral Dissertation for the degree of Doctor of the Sciences, Saint - Petersburg, Saint - Petersburg Technical University, 2011]. The filament is made of a catalyst material: iron or nickel. By passing a current through it, resistive heating takes place, whereby it is heated, and the surface of the incandescent filament evaporates catalyst substance. Then the vapor of the catalyst material is cooled and condensed resulting in the formation of the catalyst nanoparticles. The thus obtained catalyst nanoparticles are mixed with a carbon source in the reaction chamber. Carbon monoxide CO is used as the carbon source for the synthesis of single-walled carbon nanotubes, and ethanol C₂H₆O or octanol C₈H₁₈O is used for producing multi-walled CNT. At appropriate temperature, carbon sources decompose, and carbon nanostructures on the surface of the catalyst nanoparticle grow.

This method, like the one described above, has a low productivity due to the small size of the reaction chamber. In addition, heating of the working mixture occurs within the reaction chamber as it moves, and this process is difficult to control. ANNA MOISALA ET AL in "Single-walled carbon nanotube synthesis using ferrocene and iron pentacarbonyl in a laminar flow reactor", CHEMICAL ENGINEERING SCIENCE, vol. 61, no. 13, 1 July 2006 (2006-07-01), pages 4393-4402, GB, ISSN: 0009-2509, DOI: 10.1016/j.ces.2006.02.020 discloses a process for producing carbon nanotubes by decomposition of carbonaceous gases in the reaction chamber in the presence of a catalyst and at a temperature of 600 to 1300° C.

A method of producing carbon nanotubes is disclosed in prior art. According to said method, the reaction chamber is maintained at 500-1200°C, and a catalyst material in vapor form is generated, said vapor is then condensed in the reaction chamber to form free catalyst nanoparticles, on the surface of which carbon nanostructures are formed by the decomposition of gaseous hydrocarbons [patent US 8137653, IPC B01J19/08, D01F9/127].

The vapor of the substance containing the catalyst is obtained by electric arc discharge, which is formed between two electrodes, at least one of which is in the shape of an open container located in the reaction chamber and filled with metal containing the catalyst. The metal melts under the action of the arc discharge, so in the method the electrode is at least partly in the molten state and serves as a source of the vapor of the material containing the catalyst.

In this method, the formation of the vapor of the substance containing the catalyst and formation of catalyst nanoparticles occurs directly in the reaction chamber. In the same chamber, the formation of carbon nanostructures takes place. As mentioned above, the presence of such different in their nature processes in one container complicates their control and optimization. Accordingly, there is a problem of controlling the properties of obtained carbon nanostructures.

Thus, the existing methods for catalytic producing of carbon nanotubes have disadvantages, which are mentioned above. Therefore, the problem is to eliminate the drawbacks of the known catalytic methods for producing carbon nanostructures, as well as to develop a relatively inexpensive method for producing carbon nanostructures in large scale and of high quality to meet the needs of a variety of different areas of their technological applications.

### DISCLOSURE OF THE INVENTION

The present invention solves the problem of developing a method for producing carbon nanostructures and an apparatus for implementation of said method. The method allows producing carbon nanostructures on a commercial scale, at the same time reducing the degree of agglomeration and the influence of the walls of the reaction chamber on the process, as well as increasing control over the process of preparation of these nanostructures.

For solving this problem, the method for producing carbon nanostructure by decomposition of hydrocarbon gases in the reaction chamber in the presence of a catalyst and at a temperature of 600-1200°C comprises the following steps:
(a) preparing a working mixture having a temperature of 400-1400°C and including nanoparticles comprising a catalyst substance, a carrier gas and gaseous hydrocarbons, wherein the nanoparticles comprising a catalyst substance have an average size of less than 100 nm, preferably 1-40 nm, and said nanoparticles are formed by condensation of the vapor or decomposition products of chemical compounds containing the catalyst material;
(b) feeding the reaction mixture into the reaction chamber having volume of at least 0.03 m ³ and having the distance between the opposite walls or its diameter of at least 0.1 m;
(c) discharging carbon nanostructures from the reaction chamber in a stream of gaseous products of hydrocarbon decomposition;
(d) separating carbon nanostructures from gaseous products of hydrocarbon decomposition, for example by filtration.

The feed rate of the working mixture in the reaction chamber is maintained such that the residence time of said mixture therein is 0.05 - 100 min.

For this method, gaseous hydrocarbons preferably are selected from the group of: natural gas, methane, ethane, propane, butane, pentane, hexane, ethylene, propylene, aliphatic hydrocarbons, hydrocarbons, in which the number of carbon atoms ranges from 1 to 10, mono-, or bicyclical aromatic hydrocarbons with fused or insulated rings and olefins CₓH₂ₓ, wherein x is 2, 3, or 4, other gaseous hydrocarbon, a hydrocarbon with a high saturated vapor pressure, ethyl alcohol, a vapor of anthracene or anthracene oil, a mixture of two, three or more thereof.

The catalyst substance for this method is selected from the following groups: Group 5 transition metal, Group 6B transition metal, Group 8 transition metal, preferably iron, or a mixture of two, three, or more elements belonging to the transition metals.

For this method a carrier gas, preferably selected from the group of an inert gas or hydrogen, nitrogen, ammonia, a hydrocarbon, alcohol vapor or a mixture of two, three or more thereof.

The nanoparticles containing the catalyst substance can include nuclei of carbon nanostructures.

Vapors containing catalyst substance can be prepared in an evaporation chamber in the atmosphere of a flow gas by electrical explosion of a wire comprising the catalyst substance, when current impulse passing through it. The current density in this case should be sufficient to transfer the wire material into the vapor phase without the formation of liquid droplets. It occurs at a current density of 10⁴ -10⁷ A/mm². A typical diameter of the wire can be selected in the range of 0.02 mm - 0.5 mm, but it is not limited by these values. Optimal wire diameters are in the range of 0.05 - 0.2 mm.

The flow gas preferably is selected from the group of: an inert gas, a hydrocarbon, nitrogen, alcohol vapor, and a mixture of two, three or more thereof.

In one of the embodiments in the step of producing a working mixture, the flow gas with the nanoparticles containing the catalyst substance can be mixed with gaseous hydrocarbons and then with a carrier gas. In this case, the flow gas can be either an inert gas or nitrogen, or hydrocarbon, or a mixture thereof.

In another embodiment, in the step of producing the working mixture, the flow gas with the nanoparticles containing the catalyst substance can be mixed with a carrier gas and further with gaseous hydrocarbons. In this case, the flow gas is either an inert gas or nitrogen.

In the step of producing a working mixture, the flow gas with the nanoparticles containing the catalyst substance can be mixed with a carrier gas. In this case, the flow gas is a gaseous hydrocarbon or a hydrocarbon mixture with an inert gas or nitrogen.

Vapors containing a catalyst substance can be prepared in the evaporation chamber by electric arc discharge that is formed between two electrodes, at least one of which contains a catalyst substance. This electrode can be shaped as an open container filled with a metal containing catalyst substance and at least partially melted.

The electrode comprising a catalyst substance is melted and vaporized under the action of the arc discharge. The resulting vapor condenses to form nanoparticles containing catalyst substance. The material of the other electrode can be, for example, graphite. In the step of preparing a working mixture, the carrier gas is passed through the evaporation chamber, where it captures nanoparticles comprising the catalyst substance, whereupon it is mixed with the gaseous hydrocarbons.

Vapor containing catalyst substance can be prepared in the evaporation chamber by electric arc discharge that is formed between two electrodes, each of which is configured as an open container filled with metal containing catalyst substance, and at least partially melted. The chamber is divided into two parts with each electrode in a separate part, and said parts are interconnected by a discharge channel, into which a plasma forming gas is supplied as a vortex-type flow. Said plasma forming gas is selected from the group of: a hydrocarbon gas, an inert gas, hydrogen, nitrogen, ammonia, and a mixture of at least two thereof. In the step of preparing a working mixture, the carrier gas is passed through the evaporation chamber, where it captures nanoparticles comprising the catalyst substance, whereupon it is mixed with the gaseous hydrocarbons.

A liquid or solid organometallic compound can be used as a source of the catalyst substance.

The liquid organometallic compound preferably is iron pentacarbonyl but not limiting the invention, and other suitable substances can be used.

The solid metal compound preferably is selected from the group of: ferrocene, nikelecene, cobaltocene, but the invention is not limited thereto, and other suitable substances can be used.

In case the organometallic compound is liquid, in the step of preparing a working mixture, the liquid organometallic compound is vaporized by heating it at least to the boiling point, and the obtained vapor is heated to at least the temperature of decomposition by mixing them with a carrier gas preheated to a temperature of 400-1400°C, or by heating them by a heater.

In the case, the organometallic compound is solid, in the step of preparing a working mixture, the organometallic compound preliminarily is melted by heating at least to its melting temperature, and then evaporated by heating at least to the boiling point, and the resulting vapors are heated at least to the temperature of their decomposition. Heating up to the decomposition temperature can be achieved by mixing the vapor with the carrier gas preheated to a temperature of 400 - 1400°C, or by heating them by a heater.

The vapors of a solid organometallic compound also can be prepared by spraying a fine powder of the compound with a spraying gas, and heating the powder-gas mixture to the boiling point of the compound. Then, the resulting vapor is heated to the decomposition temperature of the organometallic compound. If the compound is able to decompose directly from the solid state, the decomposing of the organomatallic compound takes place missing the step of evaporation, from the solid powder phase. Heating up to the decomposition temperature can be provided by traditional heaters or by mixing with hot carrier gas preheated to a temperature of 400 - 1400°C.

In the powder-gas mixture, or in a mixture of gas and vapors of the organometallic compound gaseous hydrocarbons can be introduced, e.g., thiophene or other sulfur-containing compounds or steam, in order to optimize the process of decomposition of the organometallic compound and to obtain an optimum size of the catalyst nanoparticles. For reducing the load on the heater, the gaseous hydrocarbons can be preheated to a temperature of 400°C and above.

The carrier gas after mixing with the vapor of the organometallic compound further is mixed with gaseous hydrocarbons for producing the working mixture.

Carbon nanostructures deposited or formed on the walls of the reaction chamber can be removed by mechanical means, for example, such means can be a movably mounted scraper ring located within the chamber, which during the movement along the axis of the chamber removes carbon nanostructure from the walls.

If necessary, the working mixture is further heated before being fed into the reaction chamber.

In a second aspect, the present invention is directed to an apparatus for producing carbon nanostructure which can be used for implementation of the described method. Said apparatus comprises a reaction chamber provided with an inlet and outlet for the working mixture and with an outlet for the products of hydrocarbon decomposition, characterized in that the apparatus comprises at least one means for preparing a working mixture which comprises nanoparticles containing the catalyst substance, a carrier gas, hydrocarbon gases, and a filter for separating carbon nanostructures from the gaseous products of decomposition of the hydrocarbons, wherein the reaction chamber has a volume of at least 0.03 m³ and a distance between the opposing walls of the reaction chamber, or a diameter, of at least 0.1 m and the means for preparing the working mixture comprises a mixing unit in which a carrier gas flow containing the nanoparticles is mixed with the gaseous hydrocarbons.

A means for preparing working mixture can be arranged in the first embodiment. said means can comprise an evaporation chamber provided with a source of electrical impulses. In said chamber there is a fine metal wire comprising the catalyst substance. Said wire is configured to explode when electric impulse passing through it. The density of the electric current is in the range of 10⁴ - 10⁷ A/mm² , and the chamber is provided with an input for the flow gas and an outlet for its mixture with nanoparticles containing the catalyst substance, and a unit of mixing said mixture with gaseous hydrocarbons or with the carrier gas.

The means for preparing working mixture can be arranged in the second embodiment, said means can comprise an evaporation chamber comprising two electrodes, one of which is made of a material containing a catalyst substance that is able to melt and vaporize under the action of an electric arc discharge between said electrodes, wherein the chamber is provided with an input for a carrier gas and an outlet for the mixture of the carrier gas and the nanoparticles containing the catalyst substance, and also a unit for mixing said mixture of the carrier gas with said nanoparticles and gaseous hydrocarbons. The electrode, which is made of a material comprising a catalyst substance, is able to melt and can take the shape of an open container filled with metal.

The means for preparing working mixture can be arranged in the third embodiment, said means can comprise an evaporation chamber comprising two electrodes, each electrode is made in the shape of an open container filled with a metal containing the catalyst substance and is configured to melt and vaporize under the action of an electric arc discharge between said electrodes, wherein said chamber is divided into two parts, and each electrode is located in a separate part. Said parts of the chamber are interconnected by a discharge channel, which is provided with an inlet for a plasma forming gas configured in such a manner that the plasma forming gas enters in a vortex flow, and the channel is provided with an inlet for the carrier gas and an outlet for the carrier gas mixture with nanoparticles containing the catalyst substance, and a unit for mixing the mixture of the carrier gas with said nanoparticles and gaseous hydrocarbons.

The means for preparing working mixture can be arranged in the fourth embodiment and includes an evaporation channel and decomposition channel of the liquid organometallic compound with successive heaters, an inlet for hot carrier gas with the nanoparticles containing the catalyst substance, and a unit for mixing them with gaseous hydrocarbons.

The same means for preparing a working mixture for a solid organometallic compound further is provided with a melting chamber for the organometallic compound, said chamber being connected to the evaporation channel through a dispenser.

A means for preparing working mixture can be arranged in the fifth embodiment. Said means comprises a container for the powder of the organometallic compound connected to a powder spray channel through the dispenser, which in turn is connected to the evaporation channel for the powder of the organometallic compound connected to the channel of decomposition of the organometallic substance. The channel of decomposition of the organometallic substance is provided with a carrier gas inlet and an outlet for the carrier gas with nanoparticles containing catalyst substance. Said outlet is connected to the mixing unit, which also has an inlet for hydrocarbons and an outlet for the working mixture.

The reaction chamber can also be provided with a means for cleaning the walls of nanostructures deposited or formed on the walls of the reaction chamber.

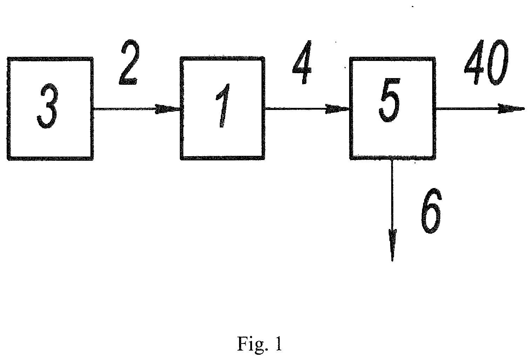

Fig. 1 shows the general diagram of the apparatus for producing carbon nanostructures and implementing the claimed method. In the Figure: 1 is the reaction chamber, 2 is the working mixture, 3 is the means for preparing the working mixture, 4 is products of hydrocarbon decomposition, 5 is a filter, 6 is carbon nanostructures, 40 is gaseous wastes.

The process is carried out as follows:
The means 3 for preparing the working mixture mixes such preformed flows that the resulting mixture comprises the carrier gas, the nanoparticles comprising the catalyst substance, and gaseous hydrocarbons. The temperature of the mixture is maintained in the range of 400 - 1400°C. In case the working mixture in the means for preparing a working mixture 3 has a lower temperature, it is further heated. The nanoparticles included in the working mixture and comprising the catalyst substance have an average size of less than 100 nm, preferably 1-40 nm and are formed by condensation of vapor, or they are products of decomposition of chemical compounds containing the catalyst substance.

The prepared working mixture 2 having above temperature is fed into the reaction chamber 1 having a volume of not less than 0.03 m³ and the distance between the opposite walls of the reaction chamber, or the diameter, of at least 0.1 m The working mixture is fed at such a rate that the time of its presence in said chamber is in the range of 0.05 - 100 min. The preferred time of the presence is 10 seconds.

For reducing the influence of the chamber walls on the formation of carbon nanostructures, it is required to minimize the number of collisions of molecules with the walls. This is achieved by increasing the size of the reaction chamber to such values that most of the gas particles during their stay in said chamber have no time to face the wall. This, in turn, is achieved under the condition that the distance between the closest walls of the chamber, or the diameter (d), is at least substantially larger than the characteristic diffusion length (L) of the mixture molecules during their residence time in the reaction chamber (t), i.e. d > L. The value of L can be estimated by the well-known formula L = (D·t)^{0.5}, where D is the diffusion coefficient. The value of the diffusion coefficient for the gas at a temperature in the reaction chamber of about 900°C is D = 10-4 m²/s. Then, for a residence time of the gas mixture t = 10 s the obtained diffusion length L = 10⁻¹ m, or a value of the distance between the opposing walls of the reaction chamber, or its diameter should be at least 0.1 m. Desirably, this distance, or the diameter of the chamber, is not less than 0.3 m. Accordingly, if there is such minimum distance between the walls, or such chamber diameter, its volume must be not less than 0.03 m³_{.}

In the reaction chamber 1 at a temperature of 600-1200°C, the decomposition of gaseous hydrocarbons of the working mixture 2 takes place leading to formation of free carbon which is formed into carbon nanostructures, such as carbon nanotubes, on the surface of the catalyst nanoparticles. The formed nanostructures with the gas consisting of the hydrocarbon decomposition products and residuesof the carrier gas 4 are withdrawn from the reaction chamber.

The gaseous hydrocarbons used in the method, advantageously belong to the group comprising: methane, ethane, propane, butane, pentane, hexane, ethylene, propylene, aliphatic hydrocarbons, hydrocarbons, in which the number of carbon atoms is between 1 and 10 (i.e. 1, 2, 3, 4, 5, 6, 7, 8, 9 or 10), mono-or bicyclic aromatic hydrocarbons and olefins CₓH₂ₓ (where x is 2, 3 or 4), vapor of anthracene or anthracene oil, other gaseous hydrocarbons, a hydrocarbon having a high vapor pressure, ethyl alcohol and a mixture thereof.The gaseous hydrocarbons are the raw material for the production of carbon nanostructures.

For isolating the carbon nanostructures as end product 6, it is required to separate the solid phase from the gaseous phase 40 passing the products of hydrocarbon decomposition through a filter 5 or a cyclone, or another equivalent means. The products of hydrocarbon decomposition can be precooled before separating the solid phase from the gas phase.

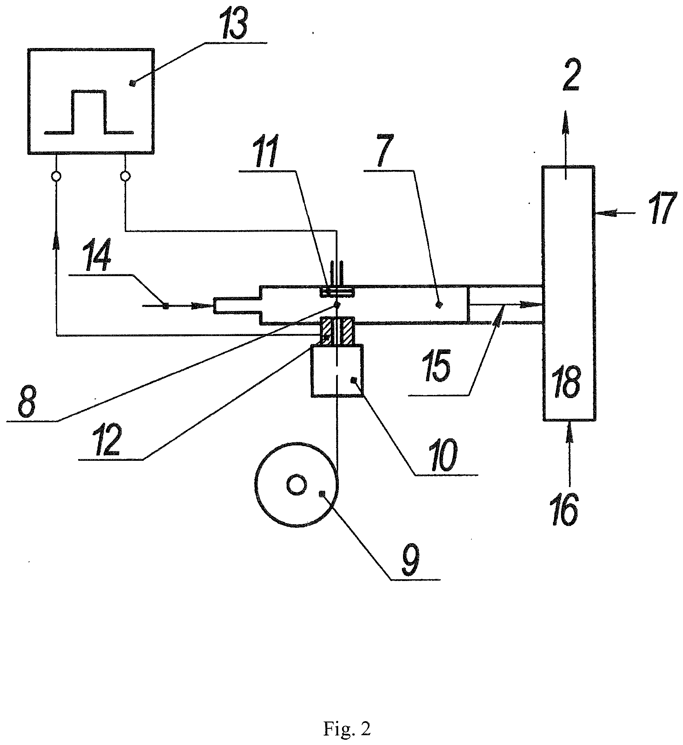

It is requires for the claimed method that free nanoparticles containing the catalyst substance are fed into the reaction chamber. These particles can be of a compound of the catalyst substance with other chemicals and a pure substance, such as iron. The nanoparticles are fed in the reaction chamber in the flow of the working mixture. The nanoparticles containing the catalyst substance, have an average size of less than 100 nm, preferably 1 - 40 HM. Such nanoparticles are prepared during the step of preparation of the working mixture by condensing vapors or products of decomposition of the chemical compounds containing the catalyst substance. Said vapors or decomposition products containing the catalyst substance are obtained in the step of preparation of the working mixture using various devices. Fig. 2 shows a means for preparing the working mixture in the first embodiment, wherein: 2 is the working mixture, 7 is the evaporation chamber, 8 is a wire, 9 is a wire coils, 10 is the means for feeding the wire, 11 is a high-voltage electrode, 12 is the electrode, 13 is a generator 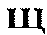 a high voltage pulses,14 is a gas flow, 15 - is a flow gas with the nanoparticles of the catalyst substance, 16 is acarrier gas, 17 is gaseous hydrocarbons, 18 is a mixing unit.

In said means for the preparation of the working mixture 2 nanoparticles comprising the catalyst substance are obtained by electric explosion of the thin metal wire 8 having the catalyst substance when passing a current pulse through it. The density of electric current flowing through said wire during the electric explosion is 10⁴ - 10⁷ A/mm² . The source of current pulses is a high-voltage pulse generator 13. The wire can be made entirely of a catalytic material, or can comprise a mixture of catalyst and other substances.

The wire is located in the evaporation chamber 7. It is wound onto the spool 9, which is controlled by a means forfeeding the wire 10. The exploding part of the wire is placed between the high voltage electrode 11 and the other electrode 12. When an impulse from the high voltage pulse generator is applied to the electrodes, the wire explodes producing a vapor containing the catalyst substance. Simultaneously, the flow gas 14 is fed into the vaporization chamber. In the atmosphere of this gas the nanoparticles are formed by condencetion of the vapor of the substance containing the catalyst. The flow gas with the nanoparticulate of the substance comprising the catalyst 15 is passed from the evaporation chamber into the mixing unit 18 where it is first mixed with a carrier gas 16. Further, the carrier gas with the nanoparticles containing a catalyst substance is mixed with gaseous hydrocarbons 17, which can be preheated to a temperature of 400°C or higher. As a result, in the mixing unit 18, all the ingredients are, and the finished working mixture 2 flows into the reaction chamber.

In the other embodiment of preparing the working mixture, the flow gas with the nanoparticle of the catalyst substance 15 is first mixed with gaseous hydrocarbons, and then with the carrier gas.

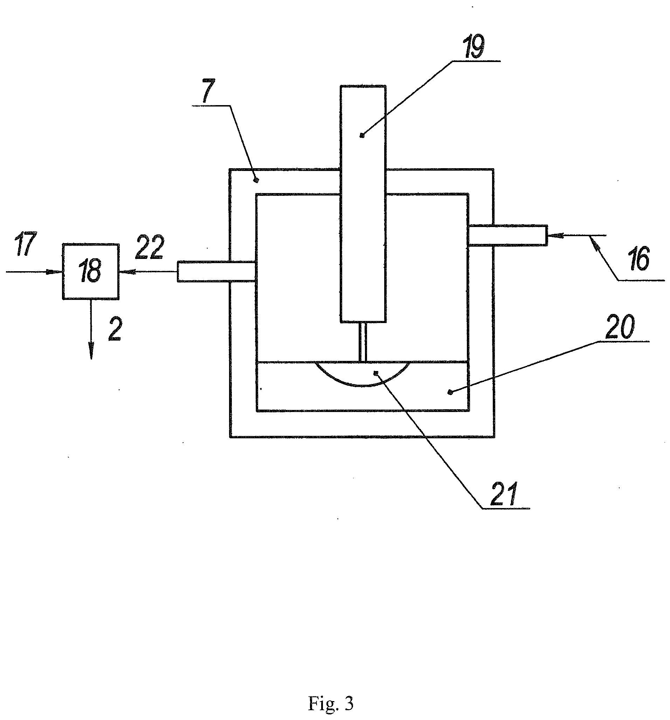

Fig. 3 shows the means for preparing the working mixture in the second embodiment, wherein:
2 is the working mixture, 7 is the evaporatioin chamber, 16 is the carrier gas, 17 is gaseous hydrocarbons, 18 is the mixing unit, 19 is the solid electrode, 20 is the partially melted electrode, 21 is the molten part of the electrode, 22 is the carrier gas with nanoparticles containing the catalyst substance.

It this means for preparation of the working mixture nanoparticles comprising the catalyst substance are obtained using an electric arc discharge between the two electrodes 19 and 20. Electrode 20 is configured in the shape of a container filled with a material capable of melting under the action of the electric arc discharge and comprising the catalyst substance. Both electrodes are placed in the evaporation chamber 7 opposite each other. When there is an electric discharge between the electrode 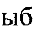 the electrode 20 begins to melt forming vapor of the catalyst substance. Said vapor enter the volume of the evaporation chamber. Simultaneously, the carrier gas is supplied to the vaporization chamber 16. In this gas, the vaporsof the catalyst substance condensate formiong nanoparticles comprising the catalyst substance. The carrier gas with nanoparticles containing the catalyst 22 substance are discharged from the evaporation chamber and fed into the mixing unit 18.

The mixing unit is also fed gaseous hydrocarbons 17, which may be preheated to a temperature not exceeding the temperature of pyrolysis, preferably not less than 400 ° C. The mixture obtained in the mixing unit is working with a mixture of 2 and is fed into the reaction chamber.

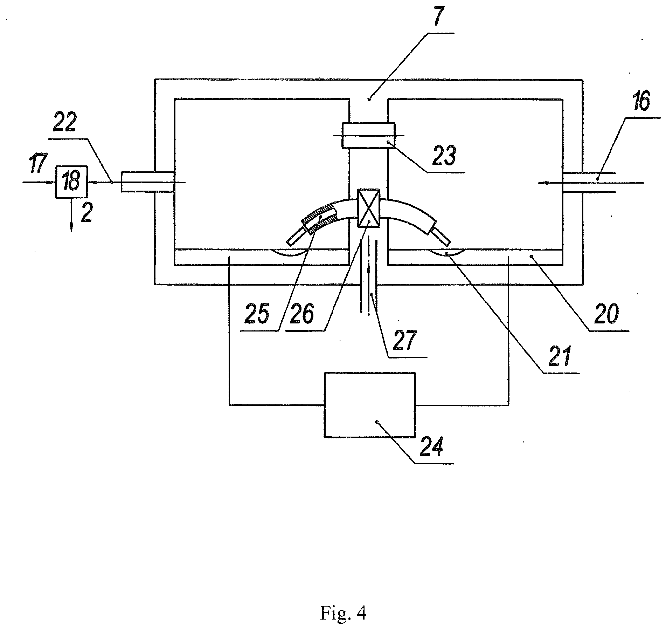

Fig. 4 shows a means for preparing the working mixture in the third embodiment, wherein:
2 is the working mixture, 7 is the evaporation chamber, 16 is the carrier gas, 17 is gaseous hydrocarbons, 18 is the mixing unit, 20 is the partially melted electrode, 21 is the melted portion of the electrode, 22 is the carrier gas with the nanoparticles, 23 is the gas channel between the parts of the evaporation chamber, 24 is the p[ower source, 25 is the discharge channel, 26 is the vortex chamber, 27 is plasma forming gas.

In this means for preparing the working mixture nanoparticles comprising a catalyst substance are obtained by electrical arc discharge between the two partially melted electrodes 20.

The evaporation chamber 7 comprises two electrodes, each shaped as a container filled with a material containing the catalyst substance, or it can directly the catalyst substance, e.g. iron.

Said means comprises two electrodes 20 located in the separate parts of the evaporation chamber 7. Both electrodes are in the shape of an open containers filled with the material comprising the catalyst substance, or directly the catalyst. Both electrodes are able to melt and vaporize under the influence of arc discharge. Two parts of the evaporation chamber 7 are interconnected by the gas channel 23 and the discharge channel 25, which is fed by the plasma forming gas 27 to maintain the electrical arc in said channel. The discharge channel through an inlet formed in the center of the channel, the plasma forming gas 27 is fed so as to form a vortex movement of the gas. This allows obtaining a stable electric arc discharge in the discharge channel. The plasma-forming gas is introduced into the discharge channel in the form of the vortex flow using traditional and well known methods. For example, the plasma-forming gas can be introduced into the discharge channel tangentially to form a vortex flow stabilizing the arc discharge.. Said plasma-forming gas can contain a gaseous hydrocarbon or an inert gas, and one or more gases from the group of nitrogen, hydrogen, and ammonia.

The evaporation chamber is provided with the inlet 16 for a carrier gas, into which
the substance containing the catalyst evaporates, and an outlet for the carrier gas with the catalyst substance nanoparticles 22. Both electrodes can be made completely of the catalyst substanse or can comprise a mixture of the catalyst and other substances. The electrode can comprise more than 20%, more than 30%, more than 40%, more than 50%, more than 60%, more than 70%, more than 80%, more than 90%, more than 95% and so on up to almost of 100% catalyst substance. Vapors containing the catalyst substance obtained by evaporation of the electrodes in the electric discharge condence in the atmosphere of the carrier gas. The electrode can be made completely of the catalyst substance or can comprise a mixture of the catalyst and other substances.

The carrier gas 22 with nanoparticels from the evaporation chamber 7 enters into the mixing unit 18 where it is mixed with gaseous hydrocarbons previously heated at least up to 400°C. It should be noted that gaseous hydrocarbons can have a different lower temperature, or even not being heated. However, when the hydrocarbons are preheated, the process of preparation of the working mixture takes less time. The prepared working mixture 2 is fed into the reaction chamber.

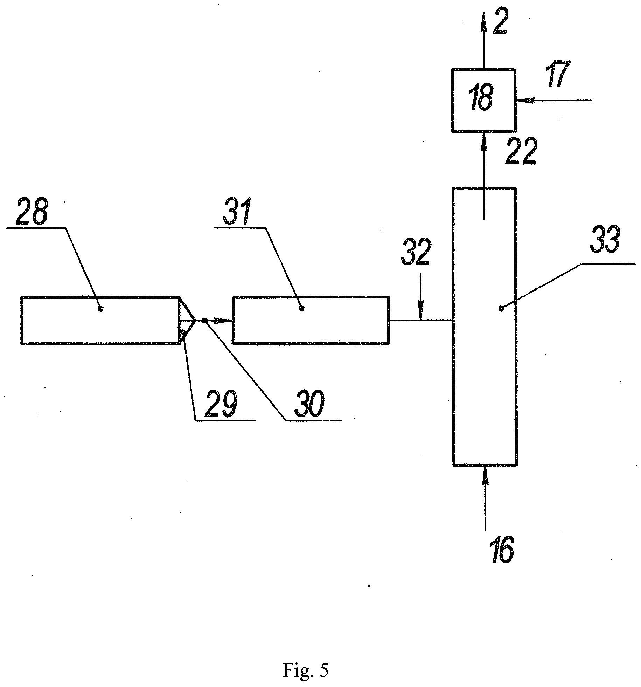

Fig. 5 shows the means for preparing the working mixture in the fourth embodiment, in which:
16 is the carrier gas, 17 is gaseous hydrocarbons, 18 is mixing unit, 22 is the carrier gas with nanoparticles, 28 is the melting chamber for the organometallic compound, 29 is dispenser, 30 is molten organometalic compound, 31 is the channel of evaporation of the organometallic compound, 32 is a vapor of the organometallic substance, 33is the decomposition channel for the organometallic compound.

In this means for preparation of the reaction mixture to obtain a nanoparticulate comprising the catalyst substyance, solid organometallic compounds are used. Initial solid organometal compound, e.g., ferrocene (CsHs Fe, is melted in the melting chamber 28, in which the temperature required for melting is provided by heaters.From the melting chamber the molten organometallic compound 30 enters the evaporation channel 31 through the dispenser 29, which allows adjusting the feed rate of the substance. The melting chamber can be configured as a syringe. In this case, it further performs the function of the dispenser. Melting occurs in the syringe when the substance is heated to an appropriate temperature by a heater. Dosing occurs at a uniform movement of the syrange piston, whereby the molten substance is extruded into the evaporation channel 31. In the evaporation channel 31 molten organometallic compound is heated to boiling by the heaters.

Vapor of the organometallic substance 32 are formed in the process of boiling. This vapor enters the decomposition channel 33 where it is mixed with the hot carrier gas 16. The evaporation and decomposition channels can be configured integrally. In this case, the vaporization and decomposition channel is provided with an inlet for the carrier gas. In the decomposition channel, the temperature is maintained not lower than the decomposition temperature of the organometallic substance. The temperature in the channel is maintained by the heaters. The temperature of the carrier gas entering the chamber is 600 - 1400°C. In the atmosphere of carrier gas, the organometallic compound is decomposed, and the decomposition products comprising the catalyst substance are condensed in nanoparticles, for example, formed by the decomposition of ferrocene nanoparticles containing iron. The carrier gas containing the nanoparticles 22 further passes to the mixing unit where it is mixed with the preheated gaseous hydrocarbons. The resulting working mixture 2 enters the reaction chamber where the processes described above take place.

This means for preparing the working mixture can be modified for liquid organometallic compounds. If liquid organometallic compounds are used in the method, there is no need for a melting chamber, and the liquid organometallic compound directly is fed into the evaporation and decomposition channel. The rest operations of preparation of the working mixture remain the same.

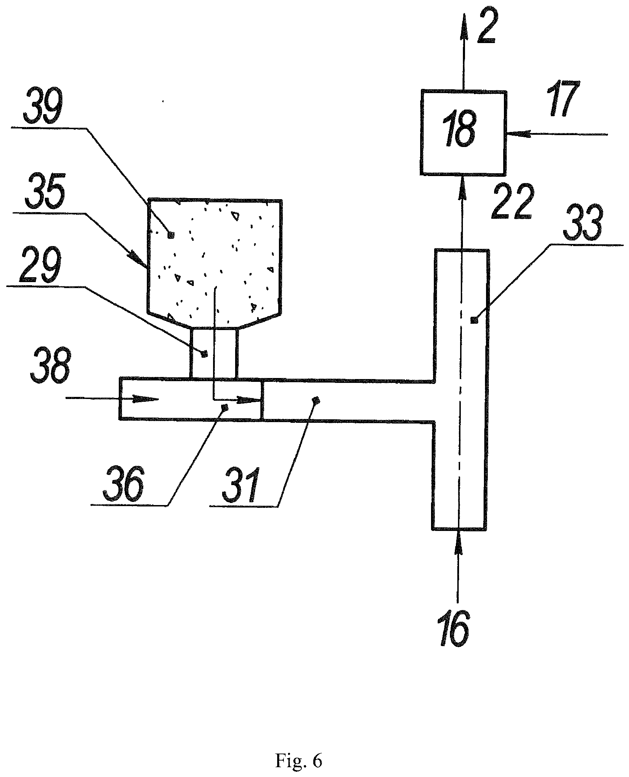

Fig. 6 shows a means of preparing the working mixture in the fifth embodiment, in which:
16 is the carrier gas, 17 is gaseous hydrocarbons, 18 is the mixing unit, 22 is the carrier gas with nanoparticles, 29 is the dispenser, 31 is the evaporation channel for the organometallic compound, 33 is the decomposition chennel for the organometallic compound, 35 is the container for the powder of the organometallic compound, 36 is the spraying channel for the organometallic compound, 38 is the spraying gas, 39 is the powder of the organometallic compound.

In this means for preparation of the reaction mixture to obtain nanoparticles comprising the catalyst substance solid organometallic compounds in the form of a fine powder are used.

The fine powder of the organometallic compound 39 is placed in the container 35 for the organometallic compound powder. The powder from the container through the dispenser 29 enters the spray channel 36, through which the spraying gas 38 is passedspraying powder particles. The spraying gas preferably is an inert gas or the same gas as the carrier gas. The powder with the gas enters the evaporation channel 31 where it is heated and vaporized. Next, the powder vepors pass into the decomposition channel 33, through which the carrier gas 16 also passes. In the decomposition channel the organometallic compound decomposes due to the high temperatures of the channel walls and the heated carrier gas 16.After the decomposition of the organometallic substance, in the carrier gas the nanoparticlescontaining the catalyst substance are condenced. The carrier gas with said nanoparticles 22 enters the mixing unit 18, to which also the gaseous hydrocarbons 17 are fed. The resulting working mixture 2 then is directed into the reaction chamber.

In the same way, liquid organometallic compounds can be used, but instead of the fine powder sprayed by gas a liquid spray is used.

The above embodiments of means for preparing the working mixture allow obtaining the working mixture with nanoparticles containing the catalyst substance with a mean size of not more than 100 nm, preferably 1-40 nm. It should be noted that the means for preparing the working mixture can have other embodiments that are not described here.

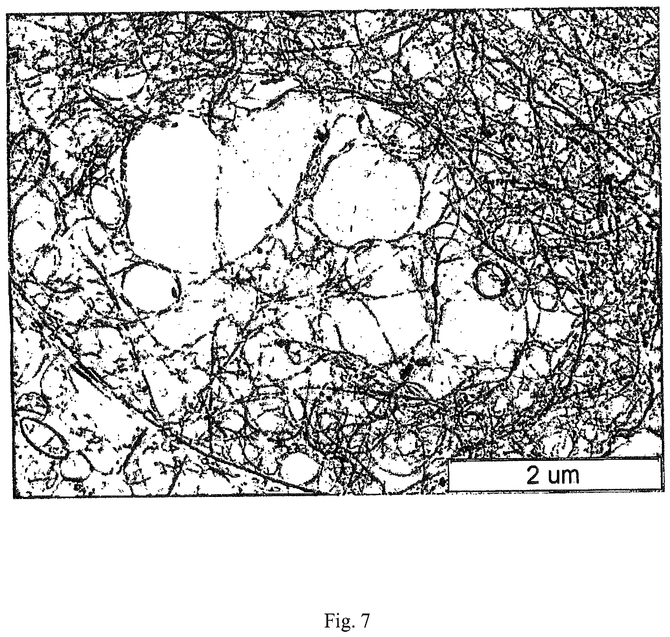

The carbon nanostrutures obtained by the method set forth herein are illustrated in Fig. 7. They are of good quality, low agglomeration, and can be produced industrially. It is possible to control the process of their preparation.

### BRIEF DESCRIPTION OF THE DRAWINGS

Fig. 1 shows a diagram of the method and apparatus for implementing said method.
Fig. 2 shows a first embodiment of the means for preparing the working mixture.
Fig. 3 shows the second embodiment of means for preparing the working mixture.
Fig. 4 shows a third embodiment of means for preparing the working mixture.
Fig. 5 shows a fourth embodiment of the means for preparing the working mixture.
Fig. 6 shows a fifth embodiment of the means for preparing the working mixture.
Fig. 7 shows the photographs of the nanomaterial obtained by the described method.

### BEST MODE FOR CARRYING OUT THE INVENTION

### EXAMPLE 1

Preparation of carbon nanostructures is carried out in accordance with the diagram shown in Fig. 1.

The means for preparing the working mixture 3 is shown schematically in Fig. 2. It comprises a vaporization chamber 7, the wire 8, the wire coil 9, the means 10 of the wire feeding, a high voltage electrode 11, an electrode system 12, high-voltage pulse generator 13, the mixing unit 18.

The wire 8 is of mild steel with a diameter of 0.08 mm is disposed in the evaporation chamber 7 as shown in Fig. 2. The wire is wound on the reel 9 from which it is unwound and fed by the feeding means of the wire 10 so that it reaches the high voltage electrode 11. Then, with the help of the generator of electrical pulses 12 between the high voltage electrode and the electrode system 12 an electric impalse is passed through the portion of the wire passing through the chamber, said electrical impulse has a current value of 700, and it is passed for approxiomately 200 ns. When this happens, the explosion of the wire portion occures, which is followed by transfer of the wire material into vapors of the wire metals including the vapor of iron. Simultaneously, the flow gas 14 is passes through the vaporization chamber 7. said flow gas 14 is a mixture of nitrogen and methane in a volume ratio of 5: 1 at a rate of 5 m³/h.Metal vapors are condensed into nanoparticles containing iron, which are the nanoparticles of the catalyst. The condensed nanoparticles with the flow gas gas 15 pass to the mixing unit 18, where they are mixed with the carrier gas 16, which is nitrogen heated to a temperature of 1200°C at a rate of 35 m³/h and with the gaseous hydrocarbon 17, which is metane heated to a temperature of 500°C at a rate of 4 m³/h.

The working mixture 2 mixed in the mixing unit is fed into the reaction chamber having a volume of 0.2 m³ and a diameter of 0.3 m. In the reaction chamber the temperature of 910°C is maintained. As a result of the catalytic decomposition of methane, carbon nanostructures grow on the iron nanoparticles. Decomposition products are subjected to filtration to obtain carbon nanomaterial. The resulting nanomaterial comprises single-walled and double-walled nanotubes, as shown in Fig. 7.

### EXAMPLE 2

Preparation of carbon nanostructures is carried out in accordance with the diagram shown in Fig. 1.

The diagram of the means for preparing the working mixture 3 is shown in Fig. 2. Nanoparticles containing the catalyst substance are obtained in the evaporation chamber 7.

The evaporation chamber 7 has two electrodes, one of which is solid, made of solid graphite 8, and the second is in the shape of an open container filled with the material containing the catalyst 9. The material filling the container is carbon steel St. 3. The container is made of graphite.

When applying a voltage to the electrodes, an arc discharge appears, wheras the current of 50 A is maintained. The steel in the container melts and evaporates to form vapor of iron. Simultaneously, the carrier gas 16 (nitroge) is supplied through the inlet of the chamber at a flow rate of 10 m ³ /h. In the atmosphere of said gas the vapor of iron is condensed in the form of nanoparticles with a characteristic average size of about 10 nm. Then the carrier gas with iron nanoparticles 21 is fed to the mixing unit 18, and gaseous hydrocarbons 17 (methane) preheated to a temperature of 500°C by heaters are also fed at a rate of 8 m ³ /h. The mixture is then mixed with the carrier gas 16 heated to a temperature of 1150°C, which is also fed to the mixing unit at a rate of 30 m ³ /h.As a result of mixing in the mixing unit, the working mixture 2 is obtained, said working mixture consisting of the carrier gas, the nanoparticles containing the catalyst substance, and the hydrocarbons.

The working mixture having a temperature of 940°C is fed into the reaction chamber 1, having a volume of 0.2 m³ and a diameter of 0.3 m. The temperature of 920°C is maintained in the reaction chamber. The residence time of the working mixture in the reaction chamber is approximately 3 minutes. As the result of the catalytic decomposition of methane, carbon nanotubes are formed on the catalyst nanoparticles and hydrogen is released. The methane decomposition products are discharged from the chamber through the outlet of the reaction chamber and after cooling passed through a filter separating the solid component of the decomposition products.

### EXAMPLE 3.

Preparation of nanostructures is carried out in accordance with the diagram shown in Fig. 1
The means for preparing the working mixture 3 is shown schematically in Fig. 4.

The nanoparticles containing the catalyst substance are prepared in the evaporation chamber.

There are two electrodes 20 in the evaporation chamber 7 configured as containers filled with a material containing the catalyst substance. The material filling the container is carbon steel St. 3.

When applying voltage to the electrodes from the source 24, an arc discharge appears in the discharge channel 25, through which the plasma forming gas 26 (nitrogen) is passed in the form of a vortex produced with the help of the vortex chamber 26, wherein the current of 90 A is maintained. Steel is melted in the containers of the electrodes 21 and evaporates to form a vapor of iron. Simultaneously, the carrier gas 16 is introduced into the chamber. Said carrier gas is a mixture of hydrogen and nitrogen in a molar ratio of 3/40. The iron vapor condenses into nanoparticles. Then the carrier gas with the iron nanoparticles is fed to the mixing unit. The gaseous hydrocarbons 17 (methane), which are preheated to a temperature of 400°C by the heater 4, also is fed to the mixing unit. As a result of the mixing in the mixing unit, the working mixture is obtained.

The working mixture 2 having a temperature of 1100°C is fed into the reaction chamber 1 having a volume of 1 m³ and a diameter of 1 m. The temperature of 945°C is maintained in the reaction chamber. The catalytic decomposition of methane tresults in growth of carbon nanotubes on the iron nanoparticles. The reaction products are passed through a filter, wherein the carbon nanomaterial is separated from the gas. The resulting nanomaterial contains iron nanoparticles in carbon shells with two or more monolayers and single-walled and multi-walled nanotubes.

### EXAMPLE 4

Preparing nanostructures is carried out in accordance with the diagram shown in Fig. 1.

The means for preparing the working mixture 3 shown schematically in Fig. 5.

Ferrocene is melted in the melting chamber 28 by heating it with the heater to a temperature of 300°C. Further melted ferrocene is fed into the evaporation channel 31 using the dispenser 29 at a rate of 20 g/h. In said channel equipped with heaters at the temperature of 400°C it evaporats. Further the ferrocene vapor is mixed with hot carrier gas 16 (nitrogen) supplied at 8 m²/h, having a temperature of 1200°C, whereby decomposition of ferrocene and further condensation of its decomposition products occur.In the atmosphere of the carrier gas, nanoparticles of an average size of 5 nm containing iron atoms are formed.

Then, the resulting nanoparticles with a stream of nitrogen 22 are supplied to the mixing unit 18, to which also supplied heated to 490°C methane at a rate of 1 m²/h .The working mixture obtained in the mixing unit 2 is fed into the reaction chamber having a volume of 0.2 m³ and a diameter of 0.3 m.

The temperature in the reaction chamber is maintained at 900°C. As a result of the catalytic decomposition of methane, carbon nanostructures grow on iron nanoparticles. The decomposition products are passed through the filter where the carbon nanostructures are deposited. The resulting nanomaterial comprises single-walled and double-walled nanotubes.

### EXAMPLE 5

Preparing nanostructures is carried out in accordance with the diagram shown in Fig. 1
The means for preparing the working mixture 3 is shown schematically in Fig. 6.

Fine powder of ferrocene 39 is fed through the dispenser 29 at a rate of 8 g/h in the spraying channel 36, where it is sprayed with nitrogen stream. Prepared powder - gas mixture is fed into the evaporation channel 31, where it is heated to a temperature of 350°C. The ferrocene powder evaporates. The resulting mixture of ferrocene vapor and nitrogen is fed into the decomposition channel 33, in which also fed the carrier gas (nitrogen) 16 at a flow rate of 30 m³ per hour at a temperature of 1200°C. In the carrier gas flow ferrocene is decomposed and nanoparticles containing iron atoms are formed. The carrier gas with the nanoparticles 22 is then fed to the mixing unit 18, in which methane 17 heated to 450°C at flow rate of 3 m³ per hour also is fed. The working mixture obtained in the mixing unit 2 flows into the reaction chamber having a volume of 0.2 m ³ and diameter of 0.3 m , which is maintained at a temperature of 960°C. As the result of the catalytic decomposition of methane, carbon nanostructures grow on the nanoparticles containing iron. The reaction products are passed through the filter, wherein the carbon nanomaterial is separated from the gas. The resulting nanomaterial comprises single-walled and double-walled nanotubes.

### INDUSTRIAL APPLICABILITY

The method and apparatus described above are designed for producing carbon nanostructures. However, this method and app aratus are presented as an example only and may not be limited to this field of application.

In turn, with regard to the nanostructures obtained using the described method and apparatus, they are associated with many the most promising directions in materials science, nanotechnology, nanoelectronics, applied chemistry and others.

For example, the carbon nanotubes can be used in the manufacture of adsorbents, catalyst substyrates, chromatographic stationary phases, a variety of composite materials. Their use is due to their properties such as mechanical strength, high electrical and thermal conductivity.

A nanotube can be used as part of a physical device for which it can be placed on the tip of a scanning tunneling and atomic force microscope as an ideal needle having a diameter of a few atoms.

It is obvious that the unusual electrical properties of nanotubes make them one of the basic materials in nanoelectronics. Prototypes of field-effect transistors based on a single nanotube already have been developed. By applying a blocking voltage of a few volts, it is possible to change the conductivity of a single-walled nanotube by 5 orders.

Another use of the tubes in nanoelectronic is creation of semiconductor heterostructures, i.e. structures such as metal/semiconductor or a junction of two different semiconductors.

The nanotubes are used in the computer industry. For example, prototypes of thin flat panel displays working on a matrix of nanotubes have been created and tested. A pixel size of such displays will be in the order of a micron.

Ultra-thin films of single-walled carbon nanotubes are used to make sensors in electronics.

Use of nanotubes in the biotechnology industry is mainly concentrated in the area of biosensors, biochips, monitoring activities and targeted drug delivery. In the next ten years, the development of biosensors and their applications in nanotechnology will allow designing and manufacturing miniature analyzers for clinical use.

Carbon nanotubes can be used to replace porous carbon in electrode-bipolar plates in fuel cells. Use of CNT increases the conductivity and surface area of electrodes, which means that it is possible to reduce the necessary amount of platinum catalyst.

Carbon nanotubes are also used as high surface area for charge accumulation and as a base for placing nanoparticles in several types of solar cells. Research is underway on the use of CNT in the field of energy-saving lighting.

Samples of lamps based on carbon nanotubes and using filaments and films of them has been produced already. Results show that such lamp is comparable to a tungsten lamp spectrum of visible light, and the average efficiency of the filaments of nanotubes is 40% higher than that of the tungsten filament at the same temperature.

It should be kept in mind that here only a small fraction of the possible applications of nanotubes is mentioned. Other nanostructures are used in the same areas as the nanotubes, and in the other fields, which suggests that their possible applications are endless.

## Claims

1. A process for producing carbon nanostructures by decomposition of hydrocarbon gases in the reaction chamber in the presence of a catalyst and at a temperature of 600 to 1200° C, **characterized in that** said process comprises the following steps:
(a) providing a working mixture at a temperature of 400 to 1400°C, said mixture including nanoparticles comprising a catalyst substance, a carrier gas and gaseous hydrocarbons, wherein said nanoparticles comprising a catalyst substance have an average size of not more than 100 nm, preferably 1 to 40 nm, and they are formed by condensation of vapour or products of decomposition of chemical compounds comprising the catalyst substance;
(b) feeding the working mixture obtained in step (a) into the reaction chamber having a volume of at least 0.03m³, and the distance between the opposite walls or its diameter of at least 0.1 m;
(c) discharging carbon nanostructures from the reaction chamber in the flow of gaseous products of the hydrocarbon decomposition;
(d) separating the carbon nanostructures from gaseous hydrocarbon decomposition products.

2. The method according to claim 1, **characterized in that** the rate of the working mixture entering the reaction chamber is maintained such that the time of residence of said mixture therein is 0.05 min to 100 min.

3. The method according to claim 1, **characterized by** one or more of the following features:
the gaseous hydrocarbon is selected from the group consisting of: natural gas, methane, ethane, propane, butane, pentane, hexane, ethylene, propylene, aliphatic hydrocarbons, hydrocarbons in which the number of carbon atoms ranges from 1 to 10, a mono- or bicyclic or insulated with coupled ring aromatic hydrocarbons and olefins CₓH₂ₓ, wherein x is 2 or 3, or 4, vapor of anthracene or anthracene oil, other gaseous hydrocarbons, a hydrocarbon having a high vapor pressure, ethyl alcohol; a mixture of two, three or more of thereof;
the catalyst substance is selected from the transition metals of the Group 5B, Group 6B, Group 8, preferably
iron, or a mixture of two, three, or more transition metals;
the carrier gas is selected from the group including: an inert gas, hydrogen, nitrogen, ammonia, a hydrocarbon, an alcohol vapor, a mixture of two, three or more thereof;
the nanoparticles comprising the catalyst substance include carbon nanostructure grains.

4. The method according to claim 1, **characterized in that** the vapors containing the catalyst substance are produced in the evaporation chamber in the flow gas atmosphere by an electrical explosion of a wire comprising the catalyst substance, when passing through said wire an impulse of current of density 104 to 107 A/mm² and the flow gas is selected from the group consisting of: an inert gas, a hydrocarbon, an alcohol vapor or a mixture of two, three or more thereof.

5. The method according to claim 3, **characterized in that** at the step of producing a working mixture, the flow gas with nanoparticles containing the catalyst substance is mixed with gaseous hydrocarbons and then obtained mixture is mixed with a carrier gas, wherein the flow gas is an inert gas, or nitrogen, or a hydrocarbon, or a mixture thereof; or
the flow gas with nanoparticles containing the catalyst substance is mixed with a carrier gas and then this mixture is mixed with gaseous hydrocarbons, wherein the flow gas is an inert gas or nitrogen; or
the flow gas with nanoparticles containing the catalyst substance is mixed with the carrier gas, wherein the flow gas is gaseous hydrocarbons or a mixture of hydrocarbons with an inert gas or nitrogen.

6. The method according to claim 1, **characterized in that** the vapor containing the catalyst substance, is prepared in the evaporation chamber by an electric arc discharge formed between two electrodes, and at least one of which is in the shape of an open container filled with metal containing the catalyst substance and at least partially melted by the electric arc discharge; or
each of said electrode is in the form of an open container filled with a metal, containing the catalyst substance, and at least partially melted by the action of the electric arc discharge, while the chamber is divided into two parts, and each electrode is located in a separate part, and said parts are interconnected through a discharge channel into which a plasma-forming gas in the form of a vortex flow is introduced, wherein
the plasma-forming gas is selected from the group consisting of: a hydrocarbon gas, an inert gas, hydrogen, nitrogen, ammonia, or a mixture of at least two thereof; and wherein at the step of preparing a working mixture, the carrier gas is passed through the evaporation chamber and then mixed with the gaseous hydrocarbons.

7. The method according to claim 1, **characterized by** one of the following features:
at the step of preparing a working mixture, a liquid organometallic compound is vaporized by heating it at least to the boiling point, and the resulting vapor is heated to at least the temperature of its decomposition, wherein the liquid organometallic compound is preferably iron pentacarbonyl; or
at the step of preparing a working mixture, the solid organometallic compound is melted by heating it at least to its melting temperature, and then it is evaporated by heating it to at least the boiling point, and the resulting vapor is heated to at least the temperature of its decomposition, wherein the organometallic compound is advantageously selected from the group consisting of: ferrocene, nikelecene, cobaltocene; or
at the step of preparing a working mixture, an organometallic substance in the form of fine powder is sprayed with a spray gas and evaporated by heating the resulting mixture at least up to the boiling point and its vapor is decomposed by further heating at least to the temperature of its decomposition; and the working mixture is heated before it is fed into the reaction chamber.

8. The method according to claim 7, **characterized in that** the vapor
of the organometallic compound is heated to its decomposition temperature by mixing with the carrier gas heated to a temperature of 400-1400°C wherein the vapor of organometallic compound before mixing with the carrier gas is preferably premixed with the gaseous hydrocarbons.

9. The method according to claim 8, **characterized in that** the gaseous hydrocarbons are preheated to a temperature not lower than 400°C.

10. The method according to claims 7, ***characterized in that*** the carrier gas after mixing with the vapor of the organometallic compound is mixed with the gaseous hydrocarbons.

11. An apparatus for producing carbon nanostructures, said apparatus comprising a reaction chamber provided with an inlet for the working mixture and an outlet for the hydrocarbon decomposition products, ***characterized in that*** the apparatus comprises at least one means for preparing a working mixture comprising nanoparticles, a carrier gas and gaseous hydrocarbons, said nanoparticles comprising a catalyst substance, and a filter for separating carbon nanostructures from the gaseous products of decomposition of hydrocarbons, wherein the reaction chamber has a volume of at least 0.03 m³ and a minimum distance between opposite walls, or a diameter, of at least 0.1 m and the means for preparing the working mixture comprises a mixing unit in which a carrier gas flow containing the nanoparticles is mixed with the gaseous hydrocarbons.

12. The apparatus according to claim 11, **characterized in that** the means for preparing the working mixture comprises one of the following:
a vaporization chamber provided with a source of electrical impulse, a comprising the catalyst substance thin metal wire placed in said vaporization chamber, said wire can explode if an impulse of electric current having density of 10⁴ - 10⁷ A/mm² is passed through it, and said chamber is provided with an inlet for the flow gas and an outlet for its mixture with nanoparticles containing the catalyst substance, and at least one mixing unit for mixing said mixture with gaseous hydrocarbons or the carrier gas or
a vaporization chamber comprising two electrodes, one of which comprises the catalyst substance and is configured to melt and vaporize under the action of the electric arc discharge between said electrodes, wherein the chamber is provided with an inlet for the carrier gas and an outlet for the mixture of the carrier gas with the nanoparticles containing the catalyst substance, and the mixing unit for mixing the carrier gas with said nanoparticles and gaseous hydrocarbons; wherein
the electrode comprising the catalyst substance is preferably in the shape of an open container filled with a metal containing the catalyst substance.

13. The apparatus according to claim 12, **characterized in that** the means for preparing the working mixture comprises one of the following:
a vaporization chamber comprising two electrodes, each of said electrodes is made in the shape of an open container filled with a metal containing the catalyst substance, and configured to melt and vaporize under the action of an electric arc discharge between said electrodes, wherein the chamber is divided into two parts, and each electrode is located in a separate part, said parts of the chamber are interconnected through a discharge channel, which is provided with an inlet for plasma forming gas, said inlet is configured so that the plasma forming gas creates a vortex in the channel, wherein the chamber is provided with an inlet for a carrier gas and an outlet for the mixture of the carrier gas and the nanoparticles containing the catalyst substance, and mixing unit for mixing the carrier gas with said nanoparticles and the gaseous hydrocarbons; or
the evaporation channel and the decomposition channel of the organometallic compound, said channels provided with heaters, an inlet for the carrier gas and an outlet for the carrier gas with nanoparticles containing the catalyst substance, and the mixing unit for mixing the carrier gas with said nanoparticles and the gaseous hydrocarbons, wherein the means for preparing the working mixture comprises a melting chamber for melting the organometallic compound, connected to the evaporation channel and configured for feeding said compound into said channel; or
an evaporating channel and the decomposition channel of the organometallic compound, said channels provided with heaters, an inlet for the gaseous hydrocarbons and an outlet for a mixture of gaseous hydrocarbons and the vapor of the organometallic compound, and a mixing unit for their mixing with the carrier gas, wherein the means for preparing the working mixture comprises a melting chamber for melting the organometallic compound, connected to the evaporation channel and configured for feeding said compound into said channel; or
the means for preparing the working mixture comprises a container for the powder of the organometallic compound, said container being connected via a dispenser to the spray channel for spraying said powder, said channel being coupled to the evaporation channel for evaporating the organometallic compound, said channel being connected to the decomposition channel of the organometallic compound, said channel having an inlet for a carrier gas and an outlet for the carrier gas with the nanoparticles containing the catalyst substance, and a mixing unit for mixing them with the gaseous hydrocarbons.

14. The apparatus according to claim13, **characterized in that** the reaction chamber is provided with a means for cleaning the walls of nanostructures deposited or formed on the walls of the reaction chamber.

## Patentansprüche

1. Verfahren zur Herstellung von Kohlenstoffnanostrukturen durch Zersetzung von Kohlenwasserstoffgasen in der Reaktionskammer in Gegenwart eines Katalysators und bei einer Temperatur von 600 bis 1.200°C, **dadurch gekennzeichnet, dass** das Verfahren die folgenden Schritte umfasst:
(a) Bereitstellen einer Arbeitsmischung bei einer Temperatur von 400 bis 1.400°C, wobei die Mischung Nanopartikel, die eine Katalysatorsubstanz umfassen, ein Trägergas und gasförmige Kohlenwasserstoffe einschließt, wobei die Nanopartikel eine Katalysatorsubstanz mit einer mittleren Größe von nicht mehr als 100 nm, vorzugsweise 1 bis 40 nm, umfassen und sie durch Kondensation von Dampf oder Produkten der Zersetzung von chemischen Verbindungen, die die Katalysatorsubstanz umfassen, gebildet sind;
(b) Zufuhr der in Schritt (a) erhaltenen Arbeitsmischung in die Reaktionskammer mit einem Volumen von mindestens 0,03 m³ und dem Abstand zwischen entgegengesetzten Wänden oder ihrem Durchmesser von mindestens 0,1 m;
(c) Entnahme von Kohlenstoffnanostrukturen aus der Reaktionskammer in dem Fluss gasförmiger Produkte der Kohlenwasserstoffzersetzung;
(d) Abtrennen der Kohlenstoffnanostrukturen von gasförmigen Kohlenwasserstoffzersetzungsprodukten.

2. Verfahren gemäß Anspruch 1, **dadurch gekennzeichnet, dass** die Rate, mit der die Arbeitsmischung in die Reaktionskammer eintritt, so gehalten wird, dass die Verweilzeit der Mischung darin 0,05 min bis 100 min ist.

3. Verfahren gemäß Anspruch 1, **gekennzeichnet durch** eines oder mehrere der folgenden Merkmale:
der gasförmige Kohlenwasserstoff ist ausgewählt aus der Gruppe, bestehend aus: Erdgas, Methan, Ethan, Propan, Butan, Pentan, Hexan, Ethylen, Propylen, aliphatischen Kohlenwasserstoffen, Kohlenwasserstoffen, in denen die Zahl von Kohlenstoffatomen von 1 bis 10 reicht, mono- oder bicyclischen aromatischen Kohlenwasserstoffen oder solchen mit isolierten oder gekoppelten Ringen und Olefinen CₓH₂ₓ, worin x 2 oder 3 oder 4 ist, Dampf von Anthracen oder Anthracenöl, anderen gasförmigen Kohlenwasserstoffen, einem Kohlenwasserstoff mit einem hohen Dampfdruck, Ethylalkohol; einer Mischung von zwei, drei oder mehreren von diesen;
die Katalysatorsubstanz ist ausgewählt aus den Übergangsmetallen der Gruppe 5B, Gruppe 6B, Gruppe 8, vorzugsweise
Eisen oder eine Mischung von zwei, drei oder mehr Übergangsmetallen;
das Trägergas ist ausgewählt aus der Gruppe, bestehend aus einem Inertgas, Wasserstoff, Stickstoff, Ammoniak, einem Kohlenwasserstoff, einem Alkoholdampf, einer Mischung von zwei, drei oder mehreren von diesen;
die Nanopartikel, die die Katalysatorsubstanz umfassen, schließen Kohlenstoffnanostrukturkörner ein.

4. Verfahren gemäß Anspruch 1, **dadurch gekennzeichnet, dass** die Dämpfe, die die Katalysatorsubstanz enthalten, in der Verdampfungskammer in der Flussgasatmosphäre hergestellt werden durch eine elektrische Explosion eines Drahts, der die Katalysatorsubstanz umfasst, wenn durch diesen Draht ein Stromimpuls der Dichte von 104 bis 107 A/mm² hindurchtritt, und das Flussgas ausgewählt ist aus der Gruppe, bestehend aus: einem Inertgas, einem Kohlenwasserstoff, einem Alkoholdampf oder einer Mischung von zwei, drei oder mehreren von diesen.

5. Verfahren gemäß Anspruch 3, **dadurch gekennzeichnet, dass** bei dem Schritt der Herstellung einer Arbeitsmischung das Flussgas mit Nanopartikeln, die die Katalysatorsubstanz enthalten, mit gasförmigen Kohlenwasserstoffen gemischt wird und dann die erhaltene Mischung mit einem Trägergas gemischt wird, wobei das Flussgas ein Inertgas oder Stickstoff oder ein Kohlenwasserstoff oder eine Mischung von diesen ist; oder
das Flussgas mit Nanopartikeln, die die Katalysatorsubstanz enthalten, mit einem Trägergas gemischt wird und dann diese Mischung mit gasförmigen Kohlenwasserstoffen gemischt wird, wobei das Flussgas ein Inertgas oder Stickstoff ist;
das Flussgas mit Nanopartikeln, die die Katalysatorsubstanz enthalten, mit dem Trägergas gemischt wird, wobei das Flussgas gasförmige Kohlenwasserstoffe oder eine Mischung von Kohlenwasserstoffen mit einem Inertgas oder Stickstoff ist.

6. Verfahren gemäß Anspruch 1, **dadurch gekennzeichnet, dass** der Dampf, der die Katalysatorsubstanz enthält, in der Verdampfungskammer hergestellt wird durch eine elektrische Bogenentladung, die zwischen zwei Elektroden gebildet ist, und mindestens eine von diesen in Form eines offenen Behälters vorliegt, der mit Metall, das die Katalysatorsubstanz enthält, gefüllt ist und durch die elektrische Bogenentladung teilweise geschmolzen wird; oder
jede der Elektroden in Form eines offenen Behälters vorliegt, der mit einem Metall gefüllt ist, das die Katalysatorsubstanz enthält, und durch die Wirkung der elektrischen Bogenentladung zumindest teilweise geschmolzen wird, während die Kammer in zwei Teile unterteilt ist und sich jede Elektrode in einem getrennten Teil befindet und die Teile miteinander über einen Entladungskanal verbunden sind, in den ein plasmabildendes Gas in Form einer Wirbelströmung eingeführt wird, wobei
das plasmabildende Gas ausgewählt ist aus der Gruppe, bestehend aus: einem Kohlenwasserstoffgas, einem Inertgas, Wasserstoff, Stickstoff, Ammoniak oder einer Mischung von mindestens zwei davon; und wobei in dem Schritt der Herstellung einer Arbeitsmischung das Trägergas durch die Verdampfungskammer hindurchtritt und dann mit den gasförmigen Kohlenwasserstoffen gemischt wird.

7. Verfahren gemäß Anspruch 1, **gekennzeichnet durch** eines der folgenden Merkmale:
in dem Schritt der Herstellung einer Arbeitsmischung wird eine flüssige Organometallverbindung verdampft, indem sie mindestens auf den Siedepunkt erhitzt wird, und der resultierende Dampf wird auf mindestens die Temperatur ihrer Zersetzung erhitzt, wobei die flüssige Organometallverbindung vorzugsweise Eisenpentacarbonyl ist; oder
in dem Schritt der Herstellung einer Arbeitsmischung wird die feste Organometallverbindung geschmolzen, indem sie mindestens auf ihren Schmelzpunkt erhitzt wird und sie wird dann verdampft, indem sie mindestens auf den Siedepunkt erhitzt wird, und der resultierende Dampf wird mindestens auf die Temperatur ihrer Zersetzung erhitzt, wobei die Organometallverbindung vorteilhaft ausgewählt ist aus der Gruppe, bestehend aus Ferrocen, Nickelocen, Cobaltocen; oder
in dem Schritt der Herstellung einer Arbeitsmischung wird einer Organometallverbindung in Form von feinem Pulver mit einem Sprühgas versprüht und durch Erhitzen der resultierenden Mischung auf mindestens auf den Siedepunkt verdampft, und ihr Dampf zersetzt, indem sie weiter auf mindestens die Temperatur ihrer Zersetzung erhitzt wird; und die Arbeitsmischung wird erhitzt, bevor sie in die Reaktionskammer zugeführt wird.

8. Verfahren gemäß Anspruch 7, **dadurch gekennzeichnet, dass** der Dampf der Organometallverbindung auf ihre Zersetzungstemperatur erhitzt wird, indem sie mit dem auf eine Temperatur von 400-1.400°C erhitzten Trägergas gemischt wird, wobei der Dampf der Organometallverbindung vor dem Mischen mit dem Trägergas vorzugsweise mit den gasförmigen Kohlenwasserstoffen vorgemischt wird.

9. Verfahren gemäß Anspruch 8, **dadurch gekennzeichnet, dass** die gasförmigen Kohlenwasserstoffe auf eine Temperatur nicht niedriger als 400°C vorgeheizt werden.

10. Verfahren gemäß Anspruch 7, **dadurch gekennzeichnet, dass** das Trägergas nach dem Mischen mit dem Dampf der Organometallverbindung mit den gasförmigen Kohlenwasserstoffen gemischt wird.

11. Apparatur zur Herstellung von Kohlenstoffnanostrukturen, wobei die Apparatur eine Reaktionskammer umfasst, die mit einem Einlass für die Arbeitsmischung und einem Auslass für die Kohlenwasserstoffzersetzungsprodukte ausgestattet ist, **dadurch gekennzeichnet, dass** die Apparatur mindestens ein Mittel zur Herstellung einer Arbeitsmischung, die Nanopartikel, ein Trägergas und gasförmige Kohlenwasserstoffe umfasst, wobei die Nanopartikel eine Katalysatorsubstanz umfassen, und einen Filter zur Abtrennung von Kohlenstoffnanostrukturen aus den gasförmigen Produkten der Zersetzung von Kohlenwasserstoffen umfasst, wobei die Reaktionskammer ein Volumen von mindestens 0,03 m³ und einen minimalen Abstand zwischen entgegengesetzten Wänden oder einen Durchmesser von mindestens 0,1 m hat und das Mittel zur Herstellung der Arbeitsmischung eine Mischungseinheit umfasst, in der ein Trägergasfluss, der die Nanopartikel enthält, mit den gasförmige Kohlenwasserstoffen gemischt wird.

12. Apparatur gemäß Anspruch 11, **dadurch gekennzeichnet, dass** das Mittel zur Herstellung der Arbeitsmischung eines der folgenden umfasst:
eine Verdampfungskammer, die mit einer Quelle eines elektrischen Impulses versehen ist, einen, die Katalysatorsubstanz umfassenden dünnen Metalldraht, der in der Verdampfungskammer angebracht ist, wobei der Draht explodieren kann, wenn ein Impuls von elektrischem Strom mit einer Dichte von 10⁴ - 10⁷ A/mm² durch ihn hindurchgeleitet wird, und die Kammer mit einem Einlass für das Flussgas und einem Auslass für seine Mischung mit Nanopartikeln, die die Katalysatorsubstanz enthalten, und mindestens einer Mischungseinheit zum Mischen der Mischung mit gasförmigen Kohlenwasserstoffen oder dem Trägergas ausgestattet ist, oder
eine Verdampfungskammer, die zwei Elektroden umfasst, von denen eine die Katalysatorsubstanz umfasst und eingerichtet ist, unter der Wirkung der elektrischen Bogenentladung zwischen den Elektroden zu schmelzen und zu verdampfen, wobei die Kammer mit einem Einlass für das Trägergas und einem Auslass für die Mischung des Trägergases mit den Nanopartikeln, die die Katalysatorsubstanz enthalten, und der Mischungseinheit für das Mischen des Trägergases mit den Nanopartikeln und gasförmigen Kohlenwasserstoffen ausgestattet ist; wobei
die Elektrode, die die Katalysatorsubstanz umfasst, vorzugsweise in der Form eines offenen Behälters, der mit einem Metall, das die Katalysatorsubstanz enthält, gefüllt ist, vorliegt.

13. Apparatur gemäß Anspruch 12, **dadurch gekennzeichnet, dass** das Mittel zur Herstellung der Arbeitsmischung eines der folgenden umfasst:
eine Verdampfungskammer, die zwei Elektroden umfasst, wobei jede der Elektroden in der Form eines offenen Behälters, der mit einem Metall, der die Katalysatorsubstanz enthält, gefüllt ist, gefertigt ist und eingerichtet ist, unter der Wirkung einer elektrischen Bogenentladung zwischen den Elektroden zu schmelzen und zu verdampfen, wobei die Kammer in zwei Teile unterteilt ist und jede Elektrode sich in einem getrennten Teil befindet, wobei Teile der Kammer miteinander durch einen Entladungskanal verbunden sind, der mit einem Einlass für plasmabildendes Gas versehen ist, wobei der Einlass so eingerichtet ist, dass das plasmabildende Gas einen Wirbel in der Kammer erzeugt, wobei die Kammer mit einem Einlass für ein Trägergas und einem Auslass für die Mischung des Trägergases und der Nanopartikel, die die Katalysatorsubstanz enthalten, und einer Mischungseinheit zum Mischen des Trägergases mit den Nanopartikeln und den gasförmigen Kohlenwasserstoffen ausgestattet ist; oder
den Verdampfungskanal oder den Zersetzungskanal der Organometallverbindung, wobei die Kanäle mit Heizungen versehen sind, einen Einlass für das Trägergas und einen Auslass für das Trägergas mit Nanopartikeln, die die Katalysatorsubstanz enthalten, und die Mischungseinheit zum Mischen des Trägergases mit den Nanopartikeln und den gasförmigen Kohlenwasserstoffen, wobei das Mittel zur Herstellung der Arbeitsmischung eine Schmelzkammer zum Schmelzen der Organometallverbindung, die mit dem Verdampfungskanal verbunden ist und eingerichtet ist, die Verbindung in den Kanal zuzuführen, umfasst; oder
einen Verdampfungskanal und den Zersetzungskanal der Organometallverbindung, wobei die Kanäle mit Heizungen versehen sind, einen Einlass für die gasförmigen Kohlenwasserstoffe und einen Auslass für eine Mischung von gasförmigen Kohlenwasserstoffen und den Dampf der Organometallverbindung und eine Mischungseinheit für ihr Mischen mit dem Trägergas, wobei das Mittel zur Herstellung der Arbeitsmischung eine Schmelzkammer zum Schmelzen der Organometallverbindung, die mit dem Verdampfungskanal verbunden ist und eingerichtet ist, die Verbindung in den Kanal zuzuführen, umfasst; oder
das Mittel zur Herstellung der Arbeitsmischung einen Behälter für das Pulver der Organometallverbindung umfasst, wobei der Behälter über einen Verteiler mit dem Sprühkanal für das Versprühen des Pulvers verbunden ist, wobei der Kanal an den Verdampfungskanal zur Verdampfung der Organometallverbindung gekoppelt ist, wobei der Kanal mit dem Zersetzungskanal der Organometallverbindung verbunden ist, wobei der Kanal einen Einlass für ein Trägergas und einen Auslass für das Trägergas mit den Nanopartikeln, die die Katalysatorsubstanz enthalten, und eine Mischungseinheit für ihre Mischung mit den gasförmigen Kohlenwasserstoffen aufweist.

14. Apparatur gemäß Anspruch 13, **dadurch gekennzeichnet, dass** die Reaktionskammer mit einem Mittel zur Reinigung der Wände von Nanostrukturen, die auf den Wänden der Reaktionskammer abgeschieden oder gebildet sind, ausgestattet ist.

## Revendications

1. Procédé de production de nanostructures de carbone par décomposition de gaz d'hydrocarbures dans la chambre de réaction en présence d'un catalyseur et à une température de 600 à 1200 °C, **caractérisé en ce que** ledit procédé comprend les étapes suivantes :
(a) fourniture d'un mélange de travail à une température de 400 à 1400 °C, ledit mélange incluant des nanoparticules comprenant une substance catalytique, d'un gaz porteur et d'hydrocarbures gazeux, dans lequel lesdites nanoparticules comprenant une substance catalytique ont une taille moyenne ne dépassant pas 100 nm, de préférence de 1 à 40 nm, et sont formées par condensation de vapeur ou de produits de décomposition de composés chimiques comprenant la substance catalytique ;
(b) introduction du mélange de travail obtenu à l'étape (a) dans la chambre de réaction ayant un volume d'au moins 0,03 m³, et la distance entre les parois opposées ou son diamètre d'au moins 0,1 m ;
(c) déchargement de nanostructures de carbone de la chambre de réaction dans le flux de produits gazeux de la décomposition d'hydrocarbures ;
(d) séparation des nanostructures de carbone des produits de décomposition des hydrocarbures gazeux.

2. Procédé selon la revendication 1, **caractérisé en ce que** le débit du mélange de travail entrant dans la chambre de réaction est maintenu de telle sorte que le temps de séjour dudit mélange dans celle-ci soit compris entre 0,05 min et 100 min.

3. Procédé selon la revendication 1, **caractérisé par** une ou plusieurs des caractéristiques suivantes :
l'hydrocarbure gazeux est choisi dans le groupe constitué par : gaz naturel, méthane, éthane, propane, butane, pentane, hexane, éthylène, propylène, hydrocarbures aliphatiques, hydrocarbures dont le nombre d'atomes de carbone est compris entre 1 et 10, des hydrocarbures mono- ou bicycliques ou isolés avec des hydrocarbures aromatiques cycliques couplés et des oléfines CₓH₂ₓ, dans lequel x est 2 ou 3, ou 4, vapeur d'anthracène ou d'huile d'anthracène, autres hydrocarbures gazeux, hydrocarbure ayant une pression de vapeur élevée, alcool éthylique ; un mélange de deux, trois ou plus de ceux-ci ;
la substance catalytique est sélectionnée parmi les métaux de transition du groupe 5B, du groupe 6B, du groupe 8, de préférence
le fer, ou un mélange de deux, trois métaux de transition ou plus ;
le gaz porteur est choisi dans le groupe incluant : un gaz inerte, de l'hydrogène, de l'azote, de l'ammoniac, un hydrocarbure, une vapeur d'alcool, un mélange de deux, trois ou plus de ceux-ci ; les nanoparticules comprenant la substance catalytique incluent des grains de nanostructure de carbone.

4. Procédé selon la revendication 1, **caractérisé en ce que** les vapeurs contenant la substance catalytique sont produites dans la chambre d'évaporation dans l'atmosphère de gaz d'écoulement par une explosion électrique d'un fil comprenant la substance catalytique, lors du passage à travers ledit fil d'une impulsion de courant d'une densité de 104 à 107 A/mm² et le gaz d'écoulement est choisi dans le groupe constitué par : un gaz inerte, un hydrocarbure, une vapeur d'alcool ou un mélange de deux, trois ou plus de ceux-ci.

5. Procédé selon la revendication 3, **caractérisé en ce qu'**à l'étape de production d'un mélange de travail, le gaz d'écoulement avec des nanoparticules contenant la substance catalytique est mélangé à des hydrocarbures gazeux, puis le mélange obtenu est mélangé à un gaz porteur, dans lequel le gaz d'écoulement est un gaz inerte, ou de l'azote, ou un hydrocarbure, ou un mélange de ceux-ci ; ou
le gaz d'écoulement avec des nanoparticules contenant la substance catalytique est mélangé à un gaz porteur, puis ce mélange est mélangé à des hydrocarbures gazeux, dans lequel le gaz d'écoulement est un gaz inerte ou de l'azote ; ou
le gaz d'écoulement avec des nanoparticules contenant la substance catalytique est mélangé au gaz porteur, dans lequel le gaz d'écoulement est constitué d'hydrocarbures gazeux ou d'un mélange d'hydrocarbures avec un gaz inerte ou de l'azote.

6. Procédé selon la revendication 1, **caractérisé en ce que** la vapeur contenant la substance catalytique est préparée dans la chambre d'évaporation par une décharge d'arc électrique formée entre deux électrodes, dont l'une au moins a la forme d'un récipient ouvert rempli de métal contenant la substance catalytique et au moins partiellement fondu par la décharge d'arc électrique ; ou
chacune desdites électrodes se présente sous la forme d'un récipient ouvert rempli d'un métal, contenant la substance catalytique, et au moins partiellement fondu par l'action de la décharge d'arc électrique, tandis que la chambre est divisée en deux parties, et que chaque électrode est située dans une partie distincte, et lesdites parties sont reliées entre elles par un canal de décharge dans lequel est introduit un gaz plasmagène sous la forme d'un flux tourbillonnaire, dans lequel
le gaz plasmagène est choisi dans le groupe constitué par : un gaz d'hydrocarbures, un gaz inerte, de l'hydrogène, de l'azote, de l'ammoniac ou un mélange d'au moins deux de ceux-ci ; et dans lequel, lors de l'étape de préparation d'un mélange de travail, le gaz porteur passe à travers la chambre d'évaporation et est ensuite mélangé aux hydrocarbures gazeux.

7. Procédé selon la revendication 1, **caractérisé par** l'une des caractéristiques suivantes :
à l'étape de préparation d'un mélange de travail, un composé organométallique liquide est vaporisé en le chauffant au moins jusqu'au point d'ébullition, et la vapeur résultante est chauffée au moins jusqu'à la température de sa décomposition, dans lequel le composé organométallique liquide est de préférence du pentacarbonyle de fer ; ou
à l'étape de préparation d'un mélange de travail, le composé organométallique solide est fondu en le chauffant au moins jusqu'à sa température de fusion, après quoi il est évaporé en le chauffant au moins jusqu'au point d'ébullition, et la vapeur qui en résulte est chauffée au moins jusqu'à la température de sa décomposition, dans lequel le composé organométallique est avantageusement choisi dans le groupe constitué par : ferrocène, nikelecène, cobaltocène ; ou
à l'étape de préparation d'un mélange de travail, une substance organométallique sous forme de poudre fine est pulvérisée avec un gaz de pulvérisation et évaporée en chauffant le mélange résultant au moins jusqu'au point d'ébullition et sa vapeur est décomposée en la chauffant à nouveau au moins jusqu'à la température de sa décomposition ; et le mélange de travail est chauffé avant d'être introduit dans la chambre de réaction.

8. Procédé selon la revendication 7, **caractérisé en ce que** la vapeur
du composé organométallique est chauffée à sa température de décomposition par le mélange avec le gaz porteur chauffé à une température de 400 à 1400 °C dans lequel la vapeur du composé organométallique avant d'être mélangée au gaz porteur est de préférence prémélangée aux hydrocarbures gazeux.

9. Procédé selon la revendication 8, **caractérisé en ce que** les hydrocarbures gazeux sont préchauffés à une température non inférieure à 400 °C.

10. Procédé selon la revendication 7, **caractérisé en ce que** le gaz porteur, après avoir été mélangé à la vapeur du composé organométallique, est mélangé aux hydrocarbures gazeux.

11. Appareil pour la production de nanostructures de carbone, ledit appareil comprenant une chambre de réaction munie d'une entrée pour le mélange de travail et d'une sortie pour les produits de décomposition des hydrocarbures, ***caractérisé en ce que*** l'appareil comprend au moins un moyen permettant de préparer un mélange de travail comprenant des nanoparticules, un gaz porteur et des hydrocarbures gazeux, lesdites nanoparticules comprenant une substance catalytique, et un filtre pour séparer les nanostructures de carbone des produits gazeux de la décomposition des hydrocarbures, la chambre de réaction a un volume d'au moins 0,03 m³ et une distance minimale entre des parois opposées, ou un diamètre, d'au moins 0,1 m, et le moyen de préparation du mélange de travail comprend une unité de mélange dans laquelle un flux de gaz porteur contenant les nanoparticules est mélangé avec les hydrocarbures gazeux.

12. Appareil selon la revendication 11, **caractérisé en ce que** le moyen de préparation du mélange de travail comprend l'un des éléments suivants :
une chambre de vaporisation munie d'une source d'impulsion électrique, un fil métallique fin comprenant la substance catalytique placé dans ladite chambre de vaporisation, ledit fil pouvant exploser si une impulsion de courant électrique ayant une densité de 10⁴ à 10⁷ A/mm² le traverse,
et ladite chambre est pourvue d'une entrée pour le gaz d'écoulement et d'une sortie pour son mélange avec des nanoparticules contenant la substance catalytique, et d'au moins une unité de mélange pour mélanger ledit mélange avec des hydrocarbures gazeux ou le gaz porteur ou
une chambre de vaporisation comprenant deux électrodes, dont l'une comprend la substance catalytique et est configurée pour fondre et se vaporiser sous l'action de la décharge d'arc électrique entre lesdites électrodes, dans lequel la chambre est dotée d'une entrée pour le gaz porteur et d'une sortie pour le mélange du gaz porteur avec les nanoparticules contenant la substance catalytique, et de l'unité de mélange pour mélanger le gaz porteur avec lesdites nanoparticules et les hydrocarbures gazeux ; dans lequel
l'électrode comprenant la substance catalytique se présente de préférence sous la forme d'un récipient ouvert rempli d'un métal contenant la substance catalytique.

13. Appareil selon la revendication 12, **caractérisé en ce que** le moyen de préparation du mélange de travail comprend l'un des éléments suivants :
une chambre de vaporisation comprenant deux électrodes, chacune desdites électrodes se présente sous la forme d'un récipient ouvert rempli d'un métal contenant la substance catalytique, et configuré pour fondre et se vaporiser sous l'action d'une décharge d'arc électrique entre lesdites électrodes, dans lequel la chambre est divisée en deux parties, et chaque électrode est située dans une partie distincte, lesdites parties de la chambre sont reliées entre elles par un canal de décharge, qui est pourvu d'une entrée pour le gaz plasmagène, ladite entrée est configurée de sorte que le gaz plasmagène crée un tourbillon dans le canal, dans lequel la chambre est pourvue d'une entrée pour un gaz porteur et d'une sortie pour le mélange du gaz porteur et des nanoparticules contenant la substance catalytique, et d'une unité de mélange pour mélanger le gaz porteur avec lesdites nanoparticules et les hydrocarbures gazeux ; ou
le canal d'évaporation et le canal de décomposition du composé organométallique, lesdits canaux étant pourvus de réchauffeurs, d'une entrée pour le gaz porteur et d'une sortie pour le gaz porteur avec des nanoparticules contenant la substance catalytique, et de l'unité de mélange pour mélanger le gaz porteur avec lesdites nanoparticules et les hydrocarbures gazeux, dans lequel le moyen de préparation du mélange de travail comprend une chambre de fusion pour faire fondre le composé organométallique, reliée au canal d'évaporation et configurée pour introduire ledit composé dans ledit canal ; ou
un canal d'évaporation et un canal de décomposition du composé organométallique, lesdits canaux étant pourvus de réchauffeurs, d'une entrée pour les hydrocarbures gazeux et d'une sortie pour un mélange d'hydrocarbures gazeux et de la vapeur du composé organométallique, et d'une unité de mélange pour les mélanger avec le gaz porteur, dans lequel le moyen de préparation du mélange de travail comprend une chambre de fusion pour faire fondre le composé organométallique, reliée au canal d'évaporation et configurée pour introduire ledit composé dans ledit canal ; ou
le moyen pour préparer le mélange de travail comprend un récipient pour la poudre du composé organométallique, ledit récipient étant relié par un distributeur au canal de pulvérisation pour la pulvérisation de ladite poudre, ledit canal étant couplé au canal d'évaporation pour l'évaporation du composé organométallique, ledit canal étant relié au canal de décomposition du composé organométallique, ledit canal ayant une entrée pour un gaz porteur et une sortie pour le gaz porteur avec les nanoparticules contenant la substance catalytique, ainsi qu'une unité de mélange pour les mélanger aux hydrocarbures gazeux.

14. Appareil selon la revendication 13, **caractérisé en ce que** la chambre de réaction est pourvue d'un moyen permettant de nettoyer les parois de nanostructures déposées ou formées sur les parois de la chambre de réaction.
